Europäisches Patentamt

European Patent Office

Office européen des brevets

(11) Veröffentlichungsnummer : **0 422 284 B1**

(12) **EUROPÄISCHE PATENTSCHRIFT**

(45) Veröffentlichungstag der Patentschrift :
**01.07.92 Patentblatt 92/27**

(21) Anmeldenummer : **89119097.7**

(22) Anmeldetag : **13.10.89**

(51) Int. Cl.⁵ : **G05B 19/405, B23B 49/00, B23Q 17/09**

(54) **Verfahren zum Prüfen des Bohrers einer Leiterplatten-Koordinatenbohrmaschine auf Bohrerbruch.**

(43) Veröffentlichungstag der Anmeldung :
**17.04.91 Patentblatt 91/16**

(45) Bekanntmachung des Hinweises auf die
Patenterteilung :
**01.07.92 Patentblatt 92/27**

(84) Benannte Vertragsstaaten :
**CH DE FR GB IT LI SE**

(56) Entgegenhaltungen :
**EP-A- 0 098 930**
**EP-A- 0 127 751**
**EP-A- 0 287 071**
**DE-U- 8 708 123**

(56) Entgegenhaltungen :
**INDUSTRIAL & PRODUCTION ENGINEERING,
Band 10, Nr. 1, 1986, Seiten 60-64, Industrial &
Production Engineering,München, DE; R. MO-
¨HL: "Workpiece and tool monitoring, fuction
checking and fault diagnosis in metal-working
production"**

(73) Patentinhaber : **KLG KAUFBEURER
LEITERPLATTEN GMBH
Ingenrieder Strasse 4
W-8950 Kaufbeuren (DE)**

(72) Erfinder : **Seitz, Helmut
König-Rudolf-Strasse 62
W-8950 Kaufbeuren (DE)**

(74) Vertreter : **Ruschke, Hans Edvard, Dipl.-Ing. et
al
Patentanwälte Ruschke & Partner
Pienzenauerstrasse 2
W-8000 München 80 (DE)**

EP 0 422 284 B1

## Beschreibung

Die vorliegende Erfindung betrifft ein Verfahren zum Prüfen des Bohrers einer Leiterplatten-Koordinatenbohrmaschine auf Bohrerbruch, nach dem Oberbegriff des Patentanspruches.

Bei der Herstellung von elektronischen Baugruppen für alle möglichen Anwendungsfälle werden sehr häufig gedruckte Schaltungen auf Leiterplatten verwendet, wobei aktive elektronische Komponenten in entsprechend angeordnete Bohrungen dieser Leiterplatte/gedruckten Schaltung eingesetzt und dort verlötet werden. Hierfür müssen also die Leiterplatten im Zuge ihrer oft in sehr hohen Stückzahlen erfolgenden Herstellung mit diesen Bohrungen versehen werden, die je nach Art der Leiterplatte in verschiedenen Durchmessern und/oder Tiefen (z.B. bei Mehrlagenplatten) und in Stückzahlen von bis zu einigen 1000 pro Leiterplatte benötigt werden. Es liegt auf der Hand, daß eine wirtschaftliche Fertigung derartiger Leiterplatten nur im Rahmen einer stark durchrationalisierten Produktion hergestellt werden können.

Zu diesem Zweck werden beispielsweise Koordinatenbohrmaschinen eingesetzt, die mit einer oder mehreren Bohrstationen ausgerüstet sind und so die Werkstücke (Leiterplatten) mit den notwendigen Bohrungen versehen, die ohne Anhalten der Bohrspindel unmittelbar nacheinander gebohrt werden. Die Bohrspindel läuft dabei mit sehr hoher Drehzahl um (bis zu 100.000 U/min) und die Bohrerdurchmesser sind in der Regel sehr klein (bis zu 0,08mm). In Abhängigkeit von der Standzeit eines einzelnen Bohrers und von den verschiedenen Bohrungsdurchmessern etc. müssen je nach vorgesehenem Arbeitsablauf die Bohrwerkzeuge ausgewechselt werden, was im Stand der Technik durch verschiedene Werkzeugwechselvorrichtungen erfolgt.

Häufig werden diese Koordinatenbohrmaschinen mit einem in einer Richtung, etwa der Y-Achse verschieblichen Werkstückschlitten (Leiterplatten-Spanntisch) versehen, der über geeignete Luftlager beispielsweise auf einer Sockelplatte extrem reibungsarm verschiebbar ist. Die Verschiebung in Richtung der X-Achse erfolgt mit Hilfe einer über diesem Tisch angeordneten balkenartigen Traverse, auf der wiederum über Luftlager ein in Querrichtung verschiebbarer Schlitten angeordnet ist. Dieser Schlitten trägt die häufig wie ein zylindrisches Bauteil ausgebildeten Bohrspindeleinheiten, die zur Erzeugung der Bohrtiefenverstellung in Z-Richtung entweder auf einem eigenen Schlitten (auf dem Querschlitten) angeordnet sind, oder selbst in Richtung der Z-Achse axial verschieblich angeordnet sind, z.B. mit Hilfe von geeigneten Luftlagern auf dem Querschlitten. Bei den hier eingesetzten Bohrspindeleinheiten handelt es sich um standardisierte, d.h. in verschiedenen Größen auf dem Markt erhältliche zylinderförmige Baugruppen, die den Antrieb und die Lagerung für die mit sehr hoher Drehzahl antreibbare eigentliche Bohrspindel mit der darin vorgesehenen Spannzange enthalten.

Da die auf dem Spanntisch angeordneten, zu bohrenden Leiterplatten bisweilen sehr groß sind und nur am Rand mit dem Spanntisch verbunden werden können, neigen sie dazu, sich zu verwerfen oder zu vibrieren etc., so daß die jeweils zu bearbeitende Leiterplatte im Interesse einer präzisen Bearbeitung während des Bohrens niederge halten werden muß. Dies geschieht durch einen besonderen Niederhalter am bohrerseitigen Ende der Bohrspindeleinheit, gegenüber der dieser Niederhalter um ein gewisses Maß axial federnd verschieblich ist, etwa aufgrund der Wirkung eines Druckluftzylinders oder einer ähnlichen Vorrichtung. Der Niederhalter dient gleichzeitig als Saugdüse zum Entfernen der beim Bohren anfallenden Bohrspäne, ist mit entsprechend vielen Saugkanälen versehen und muß zur einwandfreien Fixierung der Leiterplatte und zur Beseitigung aller Bohrspäne eine angemessene radiale Ausdehnung haben.

Bei der Herstellung von Leiterplatten etwa mit einer wie voranstehend geschilderten Werkzeugmaschine und insbesondere beim Einsatz von eine kontinuierliche Produktion fördernden Werkzeugwechselvorrichtungen stellt der bisweilen auftretende Bohrerbruch ein besonderes Problem dar.

In der EP 287 071 A2 ist eine Leiterplatten-Koordinatenbohrmaschine mit einer Werkzeugwechseleinrichtung beschrieben, wobei in dieser Anmeldung das Problem der Bohrerbruchkontrolle kurz angesprochen ist, ohne jedoch eine für alle Fälle akzeptable Lösung anzubieten. Dort ist eine für den Werkzeugwechsel benötigte Werkzeug-Spannstation an der Schmalseite des Werkstückaufspanntisches zwischen zwei Werkzeugmagazinen vorgesehen, wobei diese Spannstation gleichzeitig als Längenmeßstation des neu in die Bohrspindel eingesetzten Bohrers verwendet werden kann, um beispielsweise bei genau auszuführenden Sacklockbohrungen auf die genaue Bohrlochtiefe schließen zu können. Dies wird erreicht, indem beispielsweise ein Sensor in Form eines induktiven Näherungsschalters oder eine Meßschranke mit dem Z-Achsenvorschub gekoppelt wird: Sobald die Spitze des in die Bohrspindel fertig eingespannten, aus dem Magazin neu eingewechselten Bohrers einen bestimmten Punkt erreicht hat oder die Meßschranke durchstößt, geht ein Signal an die Steuerung für die Bohrtiefenverstellung, so daß eine präzise Information darüber erhalten werden kann, wie lang jeweils der wirksame Teil des neu eingespannten Bohrers ist. Gleichzeitig kann ein derartiger Sensor kontrollieren, ob ein Bohrer abgebrochen ist, um in diesem Falle die weitere Bearbeitung zu unterbrechen und zum Beispiel ein Warnsignal abzugeben.

Bei der im Stand der Technik praktizierten Betriebsweise dieser bekannten Leiterplatten-Koordinatenbohrmaschine gelingt es also, anläßlich des Werkzeugwechsels festzustellen, ob der auszuwechselnde Bohrer im

2

Verlauf des zuvor mit diesem Bohrer durchgeführten Arbeitsnutzens abgebrochen ist, damit nicht etwa mit dem beschädigten Bohrer ein neuer Nutzen in Angriff genommen wird. Eine solche Überprüfung des Bohrers auf Bohrerbruch am Anfang oder am Ende eines Bohrernutzens anläßlich eines Bohrerwechsels wird jedoch in vielen Fällen nicht ausreichend sein, da vielfach sehr zahlreiche gleichartige Bohrungen mit dem gleichen Bohrer erstellt werden. Es wird also häufig sehr spät bemerkt werden, daß irgendwann zuvor ein Bohrer abgebrochen ist, so daß eine rationelle Fertigung unnötig erschwert wird.

Um diesem Problem zu begegnen, sind bereits Lösungen auf dem Markt, bei denen eine Bohrer-Längenmeßstation im Niederhalter am bohrerseitigen Ende der Bohrspindeleinheit angeordnet ist. Damit wird zwar erreicht, daß kontinuierlich vor jedem Bohrhub eine Bohrerbruchkontrolle durchgeführt werden kann, doch hat sich auch diese Lösung in der Praxis nicht bewährt, weil der notwendigerweise nachgiebig gelagerte Niederhalter beim Bohren nicht völlig ruhig gehalten werden kann bzw. vibriert und weil in dem gleichzeitig als Absaugdüse ausgebildeten Niederhalter herumfliegende Bohrspäne zu Fehlmessungen führen können. Insbesondere bei sehr dünnen Bohrern und demgemäß besonders empfindlich eingestellter Längenmeßstation führt eine derartige Bohrerbruchkontrolle schnell zu Fehlmeldungen, was wiederum die rationelle Fertigung behindert und die Anwender von derart ausgerüsteten Leiterplatten-Koordinatenbohrmaschinen dazu verleitet, die Bohrerbruchkontrolle ganz abzuschalten.

Es ist hiernach die der vorliegenden Erfindung zugrundeliegende Aufgabe, das Verfahren zur Bohrerbruchkontrolle bei Leiterplatten-Bohrmaschinen, welches aus dem zuletzt diskutierten Stand der Technik bekannt ist, derart weiterzubilden, daß die Nachteile der bisher bekannten Verfahren vermieden werden. Es soll also eine Bohrerbruchkontrolle bei Leiterplatten-Bohrmaschinen angegeben werden, die auch bei besonders dünnen Bohrern zu einem sicheren Meßergebnis führt und gleichzeitig die Anzahl der Bohrerbruchkontrollen im Verlaufe eines Bohrernutzens in das Belieben des Anwenders stellt.

Diese Aufgabe wird durch die Merkmale des kennzeichnenden Teils des Anspruches 1 gelöst. Es ist möglich, die erfindungsgemäße Durchführung des Bohrprogrammes auf einer schon bekannten Leiterplatten-Koordinatenbohrmaschine etwa nach der EP 287 071 A2 durchzuführen, bei der die Spannstation der Werkzeugwechselanordnung gleichzeitig als Längenmeßstation für den in der Bohrspindel sitzenden Bohrer ausgebildet ist. Es ist jedoch auch möglich, das erfindungsgemäße Verfahren auf anderen Leiterplatten-Bohrmaschinen durchzuführen - etwa solchen, die andere Arten von Werkzeugwechselvorrichtungen aufweisen, sofern nur eine an sich bekannte Bohrer-Längenmeßstation an der Bohrmaschine oder vorzugsweise am Werkstückspanntisch möglichst in der Nähe der zu bohrenden Leiterplatte angeordnet ist, damit die Bohrspindel zu mindestens einem frei wählbaren Zeitpunkt des Bohrprogrammes einen zusätzlichen Bohrhub in die in der Nähe angeordnete Längenmeßstation zur Prüfung auf einen möglichen Bohrerbruch durchführen kann. Es ist wichtig, daß diese Bohrerbruchkontrolle bei ungebremst weiterlaufender Bohrspindel durchgeführt wird, denn angesichts der beim Bohren von Leiterplatten zur Anwendung kommenden hohen Drehzahlen würde das Abbremsen und erneute Anfahren der Bohrspindel zum Zwecke der Längenmessung bwz. Bohrerbruchkontrolle gerade bei vielen solchen Prüfvorgängen viel zu viel Zeit in Anspruch nehmen, als daß damit eine rationelle Fertigung ermöglicht würde.

Das erfindungsgemäße Verfahren wird anhand eines Ausführungsbeispiels einer bekannten Leiterplatten-Koordinatenbohrmaschine mit Werkzeugwechselvorrichtung nach der EP 287 071 A2 unter Bezugnahme auf die beigefügten Zeichnungen erläutert. Dabei wird zwar von einer Längenmeßstation Gebrauch gemacht, die in eine Spannstation integriert ist, die ihrerseits ein notwendiger Bestandteil der hier benutzten besonderen Werkzeugwechselvorrichtung ist, doch kann das erfindungsgemäße Verfahren mit den gleichen Vorteilen auch bei Bohrmaschinen mit anderen Werkzeugwechseleinrichtungen oder ganz ohne solche Einrichtungen verwendet werden, wenn nur eine Längenmeßstation irgendwo an der Bohrmaschine bzw. dem Werkstückspanntisch so angeordnet ist, daß die Bohrspindel im Verlauf des durchzuführenden Bohrprogramms ohne besonderen Zeitaufwand mindestens einen zusätzlichen Bohrhub außerhalb der aufgespannten Leiterplatte in die Längenmeßstation hinein durchführen kann.

In den Zeichnungen zeigt:

Fig. 1 eine Gesamt-Seitenansicht einer Koordinatenbohrmaschine, die nach der vorliegenden Erfindung betrieben werden kann;

Fig. 2 eine Vorderansicht der gleichen Koordinatenbohrmaschine, die mit nur einer Bohrspindel versehen ist;

Fig. 3 einen Teilausschnitt aus Fig. 2 in vergrößerter Darstellung, teilweise im Schnitt, und zwar im Augenblick des Einfahrens der Bohrspindeleinheit in die "Spannstation" der Werkzeugwechselvorrichtung, die gleichzeitig als Längenmeßstation ausgebildet ist; und

Fig. 4 ein bevorzugtes Beispiel einer kombinierten Spann- und Längenmeßstation zur Durchführung des erfindungsgemäßen Verfahrens bei dieser bekannten Werkzeugmaschine.

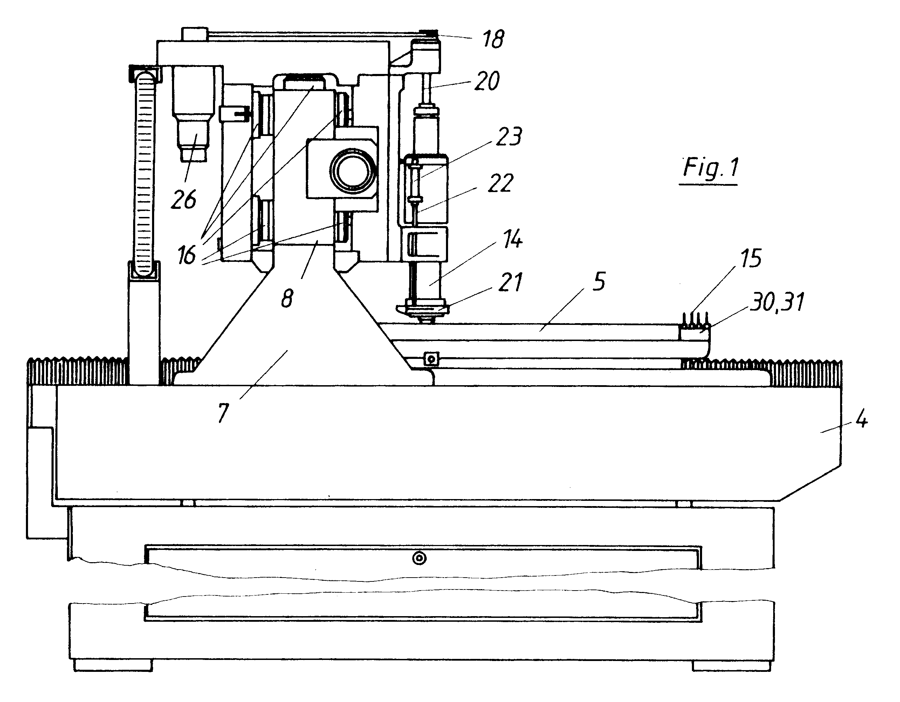

Eine Leiterplatten-Koordinatenbohrmaschine, wie sie in den Fig. 1 bis 3 dargestellt ist, gehört zusammen mit der Werkzeugwechselanordnung zum Stand der Technik. Auf einem Grundgestell 2, welches die computergestützte elektrische Steuerung für die Koordinatenbohrmaschine enthalten kann, ist eine Grundplatte 4 vorgesehen, die das Bett für die in Richtung der Y-Achse verschiebliche Werkstückaufspannplatte 5 darstellt, die über Luftlager 6 auf der Oberfläche der Granit-Grundplatte 4 abgestützt ist. Auf der Grundplatte 4 stützt sich im übrigen über entsprechende Seitenteile 7 auch noch eine brückenartige Traverse 8 für den Traversenschlitten 10 ab, der sich mit Hilfe des X-Achsenantriebes 12 quer zu der Verschiebungsrichtung der Aufnahmeplatte 5 verstellen läßt. Der Traversenschlitten 10 trägt eine Bohrspindeleinheit 14, d.h. den Antrieb und die Lagerung für die in die Bohrspindel 14 integrierte Spannzange (bei 24) zur Aufnahme der eigentlichen Bohrwerkzeuge 15. Der Traversenschlitten 10 ist wiederum über geeignete Axialluftlager 16 gegenüber der Traverse 8 extrem reibungsarm verschieblich. Die Bohrspindeleinheit 14 ist insgesamt in vertikaler Richtung, d.h. in Richtung der Z-Achse verstellbar, um die Bohrtiefenverstellung und andere, im Rahmen des Werkzeugwechsels notwendige Bewegungen durchzuführen. Die Z-Achsenverstellung der Bohrspindeleinheit erfolgt über einen entsprechenden Antrieb 26, der über einen Riementrieb 18 eine Vorschubspindel 20 verdreht, die letztlich die Axialverstellung der Bohrspindeleinheit 14 bewirkt.

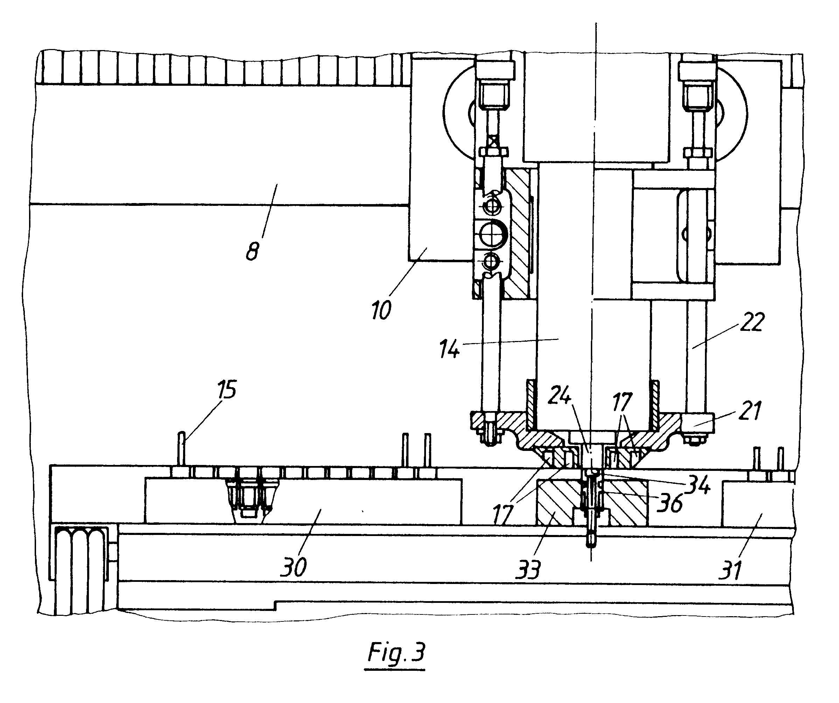

Aus Fig. 3 geht hervor, daß der der Bohrspindeleinheit 14 zugeordnete Niederhalter 21 von Führungsstangen 22 gehalten wird, die über Druckluftzylinder 23 mit der Bohrspindeleinheit 14 verbunden sind. Während des Bohrens von Leiterplatten ist der im Druckluftzylinder 23 enthaltene Kolben auf der oberen Seite mit Druckluft beaufschlagt derart, daß er sich in seiner unteren Totpunktlage befindet. Der Niederhalter befindet sich dann in einer (nicht dargestellten) Stellung unterhalb des fertig eingespannten Bohrwerkzeuges und legt sich zu Beginn der Zustellbewegung der Bohrspindeleinheit in Richtung auf die zu bohrende Leiterplatte an dieser an, um sie federnd nachgiebig niederzuhalten. Der Niederhalter, der koaxial zur Bohrspindeleinheit 14 zwischen dieser und der Werkstückspannplatte 5 angeordnet ist, dient also dazu, die bisweilen sehr großen Leiterplatten im Bereich der gerade durchgeführten Bohrung gegen die Aufnahmeplatte 5 zu drücken, damit sich die nur an ihren Rändern befestigbare Leiterplatte während des Bohrens nicht bewegt bzw. verzieht etc. Außerdem ist der Niederhalter 21 in bekannter Weise gleichzeitig als Saugdüse ausgebildet, um die beim Bohren entstehenden Bohrspäne zu entfernen. Die genaue Ausgestaltung des Niederhalters als Saugdüse ist zwar nicht dargestellt, ist aber einerseits Stand der Technik, andererseits auch für die Beurteilung der Erfindung nicht wesentlich. Für den Werkzeugwechselvorgang wird der Kolben in dem Druckzylinder 23 auf der unteren Seite mit Druckluft beaufschlagt, so daß der Niederhalter im Verhältnis zur Bohrspindeleinheit 14 nach aufwärts bewegt wird und sich von unten an deren Stirnfläche anlegt, wie dies in Fig. 3 dargestellt ist.

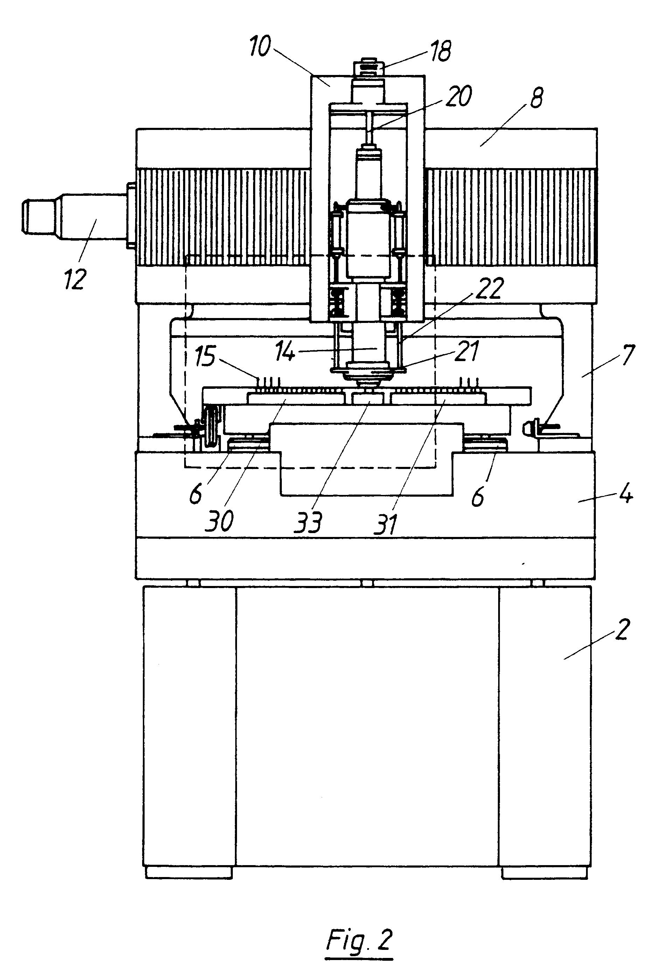

Am Rand der Aufnahmeplatte 5, d.h. im dargestellten Ausführungsbeispiel an dem der Bedienungsperson zugewandten stirnseitigen Ende in der Fig. 2 ist mindestens ein Werkzeugmagazin 30 vorgesehen, das beispielsweise in vier 12er Reihen insgesamt 48 Werkzeuge aufnimmt. Vorzugsweise kann mindestens ein weiteres Werkzeugmagazin 31 am vorderen Rand der Aufnahmeplatte 5 vorgesehen sein. Wie aus der Fig. 3 ersichtlich ist, ragen die in dem Magazin 30 bzw. 31 gespeicherten Bohrwerkzeuge 15 mit ihrem Einspannschaft nach oben aus dem Magazin heraus, so daß die Bohrspindeleinheit 14 für den Bohrerwechsel bei stillstehender Bohrspindel mit ihrer Spannzange (bei 24) bei einer entsprechenden Verstellung in X- bzw. Y-Richtung mit einem ausgewählten Werkzeug in einem der Magazine 30 oder 31 fluchtet und durch eine Zustellung in Z-Richtung das ausgewählte Werkzeug im Magazin vorläufig, d.h. am Anfang des Einspannschaftes ergreift und durch ein Zurückfahren in Z-Richtung aus dem Magazin heraushebt. Der Niederhalter 21 ist, wie dargestellt, an der den Werkzeugen 15 zugewandten Seite mit dem Werkzeugschaftdurchmesser entsprechenden Aussparungen 17 im Raster der Speicherplätze im Magazin versehen, damit die Bohrspindeleinheit 14 zusammen mit der Spannzange 24 überhaupt in die Lage versetzt wird, die Einspannschäfte der sehr dicht im Magazin 30 bzw. 31 gespeicherten Werkzeuge 15 zu ergreifen.

Nach dem Herausziehen des vorläufig ergriffenen, ausgewählten Werkzeuges aus dem Speicherplatz im Magazin wird die Bohrspindeleinheit 14 bei weiter stillstehender (nicht rotierender) Bohrspindel mit dem daran befindlichen, vorläufig gehalterten Werkzeug derart in X- und Y-Richtung verstellt, daß die Bohrspindel bzw. die Spannzange axial mit einer besonderen Spannstation 33 fluchtet, deren nähere Umgebung von Magazinplätzen freigehalten ist. Um den Einspannschaft des ausgewählten Werkzeuges, das zunächst nur an seinem obersten Ende vorläufig von der Spannzange festgehalten wird, vollends in die Spannzange 24 der Bohrspindeleinheit 14 einzudrücken, wird die Bohrspindeleinheit in Richtung auf die Spannstation 33 so vertikal verstellt, bis ein an jedem Bohrwerkzeug 15 vorgesehener Bund 34 von einer in Axialrichtung federnd gelagerten Hülse 36 in der Spannstation bis zur Anlage an der Spannzange 24 nach oben in diese hinein verschoben worden ist. Die Fig. 2 und 3 zeigen diesen Augenblick des Bewegungsablaufes der Werkzeugmaschine für den Werkzeugwechsel.

Die Bohrspindeleinheit 14 fährt also nach dem vorläufigen Ergreifen und Herausziehen des ausgewählten Werkzeuges aus dem Magazin 30 bzw. 31 über die Spannstation 33 ein, und indem die Bohrspindeleinheit 14 bei stillstehender Bohrspindel durch eine entsprechende Axialverstellung in Z-Richtung mit dem Bund 34 des

ausgewähltes Werkzeuges gegen eine federnd gelagerte Hülse 36 der Spannstation aufläuft, wird der vorläufig auf einem kurzen Stück ergriffene Einspannschaft des ausgewählten Werkzeuges vollends in die Spannzange 24 eingeschoben und dann endgültig für die Bearbeitung des Werkstückes, d.h. der zu bohrenden Leiterplatte festgespannt. Im Anschluß hieran nimmt die Bohrmaschine das normale Bohrprogramm zur Erzeugung der Leiterplattenbohrung auf.

Indem die Spannstation 33 zugleich als "Längenmeßstation" ausgebildet ist - etwa durch eine geeignete Lichtschranke oder durch induktive Mittel oder dergl. - kann sie gleichzeitig dazu dienen, im Verlauf des Werkzeugwechsels bei noch stillstehender Bohrspindel die tatsächliche Länge des fertig eingespannten Bohrers festzustellen, was dadurch geschieht, daß bei fest eingespanntem Bohrer derjenige Zeitpunkt im Verhältnis zur Z-Achsenvorschubbewegung festgestellt wird, an dem die Spitze des eingespannten Bohrers die Meßschranke der Längenmeßstation durchläuft. Damit kann die Steuerung der Bohrmaschine problemlos die für eine bestimmte Bohrerlänge notwendige Z-Achsen-Zustellung errechnen, wenn eine genau definierte Bohrtiefe verlangt wird. Darüber hinaus kann eine solche Längemeßstation erfindungsgemäß auch zur Überprüfung der Länge des Werkzeuges im Zuge des Bohrprogrammes bei laufender Arbeitsspindel eingesetzt werden: Wenn also diese bekannte Bohrmaschine in ihrem Arbeitsablauf im Zuge der Programmierung der von ihr durchzuführenden Bohrungen so programmiert wird, daß eine Längenmessung des fertig eingespannten Bohrers nicht nur anläßlich des Bohrerwechsels bei stillstehender Bohrspindel durchgeführt wird, sondern auch bei ungebremst laufender Bohrspindel zwischen den zahlreichen Bohrhüben zur Erzeugung der Bohrungen der Leiterplatte, so kann eine beliebig häufige, also quasikontinuierliche Bohrerbruchkontrolle ohne die eingangs dargestellten Nachteile des Standes der Technik stattfinden. Die Längegnmmeßstation muß nur für die Bohrspindel gut erreichbar an der Bohrmaschine, vorzugsweise am Werkstückaufspanntisch angeordnet sein, so daß sie für die hochtourig laufende Bohrspindel im Zuge der Einstellbewegungen der Bohrmaschine zur Erzeugung der einzelnen Bohrlöcher in der Leiterplatte mit einer möglichst rationellen Einstellbewegung erreichbar ist, also etwa im Sinne mindestens eines zusätzlichen "Bohrhubes" in die Längenmeßstation hinein, die zu diesem Zweck außerhalb der Grenzen der bearbeiteten Leiterplatte beispielsweise am Rand des Werkstückaufspanntisches oder am Gestell der Bohrmaschine angeordnet sein wird.

Es liegt auf der Hand, daß dieses erfindungsgemäße quasi-kontinuierliche Prüfverfahren auf Bohrerbruch für schnell arbeitende Leiterplatten-Bohrmaschinen unabhängig von einer irgendwie gearteten Werkzeugwechselvorrichtung, also insbesondere losgelöst von der oben beschriebenen Spannstation arbeiten kann, solange nur eine Längenmeßstation in der beschriebenen Weise vorgesehen wird. Tatsächlich kann es sogar bei Leiterplattenbohrmaschinen ohne Werkzeugwechselvorrichtung zur Anwendung kommen, auch wenn solche Maschinen wohl kaum wirtschaftlich fertigen können.

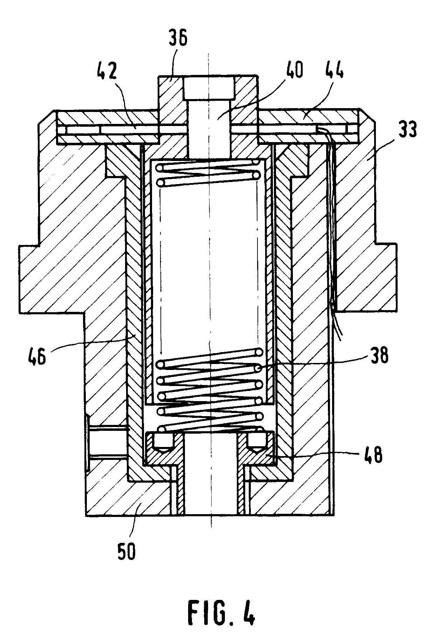

Die Fig. 4 zeigt eine Ausführungsform einer Spannstation mit integrierter Längenmeßstation in ihren konstruktiven Details: Die von einer Druckfeder 38 federnd nachgiebig gelagerte Hülse 36 weist in ihrem oberen Halsabschnitt eine axiale Öffnung 40 für den Eintritt der Bohrwerkzeuge in die Spann- und Längenmeßstation ein. Der Halsabschnitt ist mit einer die Mittellängsachse durchsetzenden radialen Bohrung versehen, die sich jeweils seitwärts (bei 42) in die die Spannstation 33 nach oben abschließende Abdeckplatte 44 fortsetzt und in der auf der einen Seite der Mittellängsachse ein Sender und auf der anderen Seite ein Empfänger zur Ausbildung der Meßschranke für die Längenmeßstation angeordnet sind. Diese Abdeckplatte 44 fixiert die federnd gelagerte Hülse 36 innerhalb einer in die Spannstation 33 eingesetzten Gleitbuchse 46, die ihrerseits mittels eines schraubenähnlichen Teils 48 an der unteren Bodenwandung 50 der Spannstation festgelegt ist.

Als besonders vorteilhaft erweist sich, wenn zwei Magazine 30, 31 - etwa beiderseits der Spannstation 33vorgesehen sind. Dadurch wird es möglich, während der Maschinenarbeitszeit ein Magazin mit verbrauchten oder nicht mehr benötigten Werkzeugen gegen ein Magazin mit neuen Werkzeugen auszutauschen, ohne deswegen die Leiterplattenbohrmaschine anhalten zu müssen bzw. eventuelle Werkzeugwechsel nicht mehr durchführen zu können. Solche Werkzeugwechsel werden in erster Linie dadurch notwendig, daß ein bestimmter Bohrer seine Standzeit überschritten hat und nachgeschliffen werden muß. Darüber hinaus können natürlich auch Bohrerwechsel dadurch notwendig werden, daß unterschiedliche Bohrungsdurchmesser gebohrt werden müssen, oder daß ein Werkzeug im Zuge der Bearbeitung abgebrochen ist.

## Patentansprüche

1. Verfahren zum Prüfen des Bohrers einer mit einem Werkstückaufspanntisch (5) versehenen Leiterplatten-Koordinatenbohrmaschine auf Bohrerbruch mit Hilfe einer Bohrer-Längenmeßstation, die an der Bohrmaschine angeordnet ist, wobei die Prüfung im Verlaufe einer großen Anzahl von gleichartigen, nacheinander ohne Anhalten der Bohrspindel (14) mit dem gleichen Bohrer (15) durchgeführten Bohrvorgängen an der Leiterplatte erfolgt, indem die Bohrerlänge bei laufender Bohrspindel festgestellt wird durch Einfahren des in der Bohrspindel sitzenden Bohrers (15) in die eine Meßschranke aufweisende Längenmeßstation und durch Vergleichen des Vorschubwertes der Bohrspindel beim Durchstoßen der Meßschranke mittels der Bohrerspitze mit einem zu Beginn des Bohrprogrammes für diesen Bohrer ermittelten Sollwert, dadurch gekenzeichnet, daß das Einfahren des Bohrers (15) in die Längenmeßstation (33) jeweils nach der Durchführung einer vorgegebenen Teilmenge der gleichartigen Bohrvorgänge nach Art mindestens eines zum gewünschten Bohrprogramm mit diesem Bohrer (15) zusätzlichen Bohrhubes in die Längenmeßstation geschieht, die außerhalb der Grenzen der auf dem Werkstückaufspanntisch (5) aufgespannten Leiterplatte am Werkstückaufspanntisch (5) angeordnet ist.

2. Verfahren nach Anspruch 1, bei dem die Längenmeßstation am vorderen Rand des Werkstückaufspanntisches (5) angeordnet ist.

3. Verfahren nach Anspruch 1 oder 2, bei dem die Längenmeßstation zugleich als Spannstation (33) eines vorbekannten Werkzeugwechselsystems ausgebildet ist.

## Claims

1. A drill fracture checking method for the drill of a jig boring machine for printed circuit boards which is provided with a workpiece mounting table (5), with the aid of a drill length measuring station which is located on the drilling machine, the checking taking place during the course of a large number of similar drilling operations on the circuit board which are performed successively with the same drill (15) without stopping the drill spindle (14), in that the drill length when the drill spindle is running is determined by introducing the drill (15) seated in the drill spindle into the length measuring station, which has a measuring barrier, and by comparing the feed value of the drill spindle upon penetrating the measuring barrier by means of the drill tip with a set value determined for this drill at the beginning of the drilling programme, characterised in that the introduction of the drill (15) into the length measuring station (33) takes place in each case after a given portion of the similar drilling operations has been performed in the manner of at least one drilling stroke into the length measuring station, additional to the desired drilling programm with said drill (15), which station is located on the workpiece mounting table (5) outside the boundaries of the circuit board clamped to the workpiece mounting table (5).

2. A method according to Claim 1, in which the length measuring station is located on the front edge of the workpiece mounting table (5).

3. A method according to Claim 1 or 2, in which the length measuring station is designed at the same time as a clamping station (33) of an already-known tool-changing system.

## Revendications

1. Procédé de contrôle de fracture du foret d'une machine à percer des plaques imprimées pourvue d'une table de serrage de pièce (5) à l'aide d'une station de mesure de longueur de foret, qui est agencée sur la machine à percer, le contrôle ayant lieu au cours d'un grand nombre de processus de perçage de la plaque imprimée qui sont d'un même type et qui sont effectués l'un après l'autre, sans arrêt de la broche de perçage (14), avec le même foret (15), la longueur de foret étant constatée lorsque la broche de perçage est en marche par une entrée du foret (15), situé dans la broche de perçage dans la station de mesure de longueur présentant une armoire de mesure et par comparaison de la valeur d'avance de la broche de perçage au cours du passage à travers l'armoire de mesure au moyen de la pointe du foret avec une valeur de consigne déterminée au commencement du programme de perçage pour ce foret, caractérisé en ce que l'entrée du foret (15) dans la station de mesure de longueur (33) est effectuée respectivement après la mise en oeuvre d'une quantité partielle prédéterminée des processus de perçage d'un même type suivant le mode d'au moins une course supplémentaire au programme de perçage souhaité avec ce foret (15) ,dans la station de mesure de longueur qui est agencée sur la table de serrage de pièce (5), en dehors des limites de la plaque imprimée serrée sur la table de serrage de pièce (5).

2. Procédé suivant la revendication 1, dans lequel la station de mesure de longueur est agencée sur le bord avant de la table de serrage de pièce (5).

3. Procédé suivant l'une des revendications 1 et 2, dans lequel la station de mesure de longueur est réalisée simultanément sous la forme d'une station de serrage (33) d'un système d'échange d'outils antérieurement connu.

*Fig.1*

EP 0 422 284 B1

_Fig. 2_

Fig. 3

EP 0 422 284 B1

FIG. 4